# EUROPEAN PATENT SPECIFICATION

(11) **EP 3 611 095 B1**
(45) Date of publication and mention of the grant of the patent: **14.12.2022**
(21) Application number: 19191966.1
(22) Date of filing: 15.08.2019
(51) Int. Cl.: B64D 15/12, B64D 15/04

(54) **AIRCRAFT COMPONENT PLASMA HEATERS**
PLASMAERHITZER FÜR FLUGZEUGKOMPONENTEN
ÉLÉMENTS CHAUFFANTS À PLASMA DE COMPOSANT D'AÉRONEF

(30) Priority: 16.08.2018 US 201815998770
(43) Date of publication of application: 19.02.2020
(73) Proprietor: ROSEMOUNT AEROSPACE INC., Burnsville, MN 55306-4898 (US)
(72) Inventor: ESSAWY, Magdi A., Lakeville, MN 55044 (US); RAMTHUN, Kent A., Snakopee, MN 55379 (US)
(74) Representative: Dehns

(56) References cited:
- EP-A1- 3 133 403
- US-A1- 2004 149 734
- US-A1- 2016 108 754
- US-A1- 2017 029 123

## Description

### BACKGROUND

### 1. Field

The present disclosure relates to aircraft component heaters, e.g., air data sensor heaters.

### 2. Description of Related Art

Air data sensor probes, e.g., pitot probes, are used in flight operations of an aircraft. In such air data sensor probes, it is necessary to keep their plumbing and pneumatic tubes free of ice in order for the sensor to perform as expected. At the extremely cold temperatures in which the probes operate as an aircraft flies at high altitudes, a resistance based electric heater is traditionally used to ensure that such probes are deiced and continue to operate properly. However, such resistance based electric heaters may not be able to perform as desired.

Such conventional methods and systems have generally been considered satisfactory for their intended purpose. However, there is still a need in the art for improved aircraft air data sensor heaters that provide the reliability required in such challenging environment. The present disclosure provides a solution for this need.

US 2004/149734 A1 discloses an aircraft component according to the preamble of claim 1, and a method according to the preamble of claim 10.

US 2016/108754 A1 discloses and aircraft splitter nose with plasma de-icing for an axial turbine engine compressor, EP 3 133 403 A1 discloses systems and methods for additive manufacturing for air data probes, and US 2017/029123 A1 discloses heating for avionic equipment.

### SUMMARY

According to a first aspect, there is provided an aircraft component as set forth in claim 1.

According to a further aspect, there is provided a method as set forth in claim 10.

Embodiments of the disclosure are set forth in the dependent claims.

These and other features of the systems and methods of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, embodiments thereof will be described in detail herein below with reference to certain figures, wherein:
Fig. 1 is a schematic view of an embodiment of an aircraft component in accordance with this disclosure; and
Fig. 2 is a schematic view of an embodiment of a plasma heater disposed in an aircraft component in accordance with this disclosure.

### DETAILED DESCRIPTION

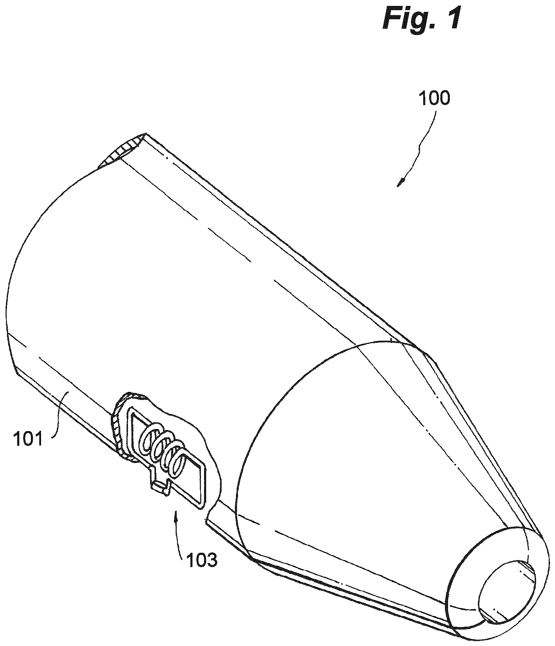

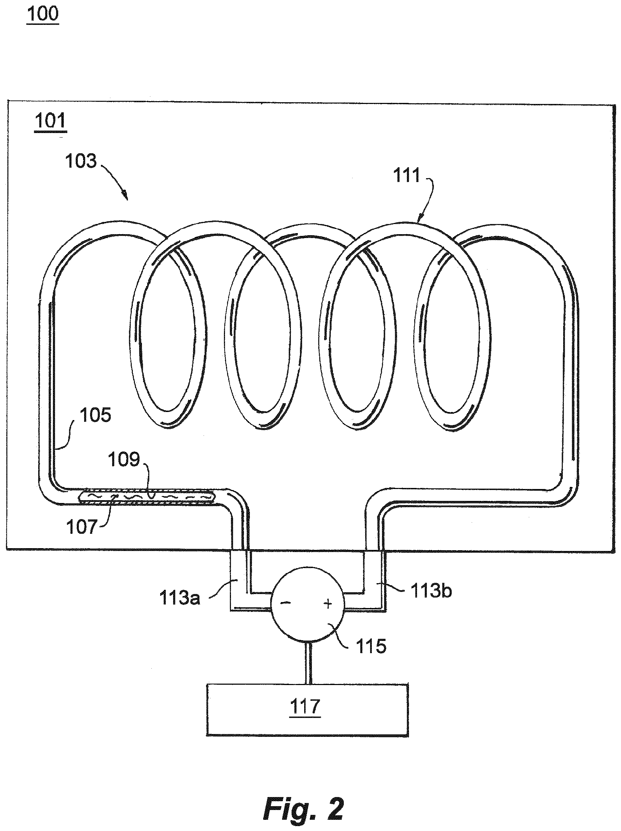

Reference will now be made to the drawings wherein like reference numerals identify similar structural features or aspects of the subject disclosure. For purposes of explanation and illustration, and not limitation, an illustrative view of an embodiment of an aircraft component in accordance with the disclosure is shown in Fig. 1 and is designated generally by reference character 100. Other embodiments and/or aspects of this disclosure are shown in Fig. 2.

Referring to Fig. 1, an aircraft component (e.g., an air data probe) 100 includes an aircraft component body 101 and a plasma heater 103 disposed at least partially on or at least partially within the component body 101 and configured to selectively heat the component body 101. The aircraft component 100 can be an air data sensor (e.g., a pitot tube as shown), and the aircraft component body 101 can be a sensor body. For example, the component body 101 can be a pitot tube, e.g., as shown in Fig. 1, for example. The aircraft component 100 can be any other variety of aircraft components (e.g., a portion of the airframe, aircraft wing and/or any other suitable type of sensor and/or traditionally heated component).

Referring additionally to Fig. 2, the plasma heater includes a vacuum tube 105 configured to retain an inert gas 107. The inert gas 107 can include one or more of, e.g., Neon, Argon, Nitrogen, or any other suitable inert gas. The vacuum tube 105 can be metallic or made of any other suitable material (e.g., a non-metallic material). In certain embodiments, the vacuum tube 105 can be coated with an insulation lining 109 configured to prevent leakage (i.e., conduction) of electric charges through the metallic vacuum tube 105, for example. Embodiments of a vacuum tube 105 are non-electrically conductive, thermally conductive, and capable of maintaining a vacuum.

In certain embodiments, the vacuum tube can be integrally formed by the component body 101 (e.g., via additively manufacturing the component body to include the vacuum tube therein). In certain embodiments, the vacuum tube 105 can be a separate piece inserted into the component body 101 (e.g., pushed into a milled hole, similar to a resistive heater). The vacuum tube 105 can at least partially form a coil 111 within or embedded around the component body 101. For example, the vacuum tube 105 can be wrapped around, forming a coil shape. Any other suitable arrangement is contemplated herein.

The vacuum tube 105 includes a first end electrode 113a and a second end electrode 113b configured to be connected to an electrical source 115 to provide an electrical potential to the inert gas 107 within the vacuum tube 105. In certain embodiments, the plasma heater 103 can include the electrical source 115. The electrical source 115 can be an aircraft power supply, for example. The electrical source 115 can be a controlled electrical source to allow high electric current to initiate the plasma and then lower current to maintain it, for example.

The plasma heater 103 can include a controller 117 configured to control the electrical source 115 (e.g., the source 115 itself and/or flow of energy from the source 115) to provide an initial electrical potential from the electrical source 115 between the first end electrode 113a and second end electrode 113b to establish a charge flow through the inert gas 107. The controller 117 can be configured to control the electrical source 115 to provide a second electrical potential lower than the first electrical potential after charge flow has been established such that the second electrical potential maintains charge flow through the inert gas 107.

In accordance with at least one aspect of this disclosure, a method includes heating an aircraft component with a plasma heater to prevent icing of the aircraft component. Heating the aircraft component can include providing an initial electrical potential to the plasma heater to establish a charge flow, and reducing the provided electrical potential to a second electrical potential to maintain a charge flow to heat the aircraft component. Any other suitable methods or portions thereof can be combined in any suitable manner with embodiments disclosed herein.

In embodiments, a plasma vacuum tube acts as a heater tube for aircraft components. The plasma warms up the surfaces of the vacuum tube 105 by means of electron interaction and is not subject to burnout, or open and short circuit failure modes as in resistive heaters. In embodiments, the electrical source can be used to create a sustainable electric arc and flow of charged ions within an enclosure of a specially designed shape to distribute heat in the aircraft component (e.g., air data probe) as needed. Embodiments can be applied to any device that requires heating on an aircraft, such as wing ice protection systems for example.

As appreciated by those having ordinary skill in the art in view of this disclosure, for the vacuum tube to sustain a plasma discharge, it should be non-conductive (e.g., inside wall of tube can be made non-conductive, e.g., through oxidization/anodization after manufacture of tube or through using a different non-conductive material than a conductive component body material to enclose and isolate the electric charges flowing through the plasms inside the tube), be able to maintain vacuum (e.g., at a vacuum pressure of about 3 to about 20 torr (about 400 to about 2666 Pa) after being sealed), have two or more electrodes, and contain an inert gas (e.g., and possibly include a getter material which can act as an ion pump sustaining the life expectancy of the vacuum tube).

In certain embodiments, an electronic circuit can be used to control electrical potential on the heater electrodes. The potential can have initially higher values that will be reduced once an electrical arc has been established. The initial higher resistance of the electrical gap can need a higher voltage to break it and generate enough charged ions to cross it. Once the electrical arc is created, a lower voltage potential is needed to sustain it and keep the plasma generated as needed through the vacuum tube. A controller can be used to control the electric potential across the heater electrodes in these two modes of operation as described above.

Embodiments allow better design for prognostics and health monitoring over the traditional resistive based heater. Embodiments allow the heater electronics to be able to provide robust predictive heater health metrics based on monitoring of power supply switching frequencies between high and low voltage potentials, for example, as would be appreciated by one having ordinary skill in the art in view of this disclosure. Embodiments of a controller can include such predictive logic to alert a user (e.g., a pilot) if a heater has failed if the power control to the heater is outside of one or more predetermined metrics, for example.

Embodiments provide an alternative to resistive type heaters for, e.g., air data probes. Embodiments are more reliable, more repeatable, and more predictable in the case of aging and failure. Embodiments are a better design over resistive heaters for prognostics and health monitoring (PHM) applications where power supply and voltage potential level switching frequencies can be used as direct indicators for heater failure.

As will be appreciated by those skilled in the art, aspects of the present disclosure may be embodied as a system, method or computer program product. Accordingly, aspects of this disclosure may take the form of an entirely hardware embodiment, an entirely software embodiment (including firmware, resident software, micro-code, etc.), or an embodiment combining software and hardware aspects, all possibilities of which can be referred to herein as a "circuit," "module," or "system." A "circuit," "module," or "system" can include one or more portions of one or more separate physical hardware and/or software components that can together perform the disclosed function of the "circuit," "module," or "system", or a "circuit," "module," or "system" can be a single self-contained unit (e.g., of hardware and/or software). Furthermore, aspects of this disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a nonexhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

A computer readable signal medium may include a propagated data signal with computer readable program code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

Program code embodied on a computer readable medium may be transmitted using any appropriate medium, including but not limited to wireless, wireline, optical fiber cable, RF, etc., or any suitable combination of the foregoing.

Computer program code for carrying out operations for aspects of this disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the this disclosure may be described above with reference to flowchart illustrations and/or block diagrams of methods, apparatus (systems) and computer program products according to embodiments of this disclosure. It will be understood that each block of any flowchart illustrations and/or block diagrams, and combinations of blocks in any flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in any flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified herein.

Those having ordinary skill in the art understand that any numerical values disclosed herein can be exact values or can be values within a range. Further, any terms of approximation (e.g., "about", "approximately", "around") used in this disclosure can mean the stated value within a range. For example, in certain embodiments, the range can be within (plus or minus) 20%, or within 10%, or within 5%, or within 2%, or within any other suitable percentage or number as appreciated by those having ordinary skill in the art (e.g., for known tolerance limits or error ranges).

The embodiments of the present disclosure, as described above and shown in the drawings, provide for improvement in the art to which they pertain. While the subject disclosure includes reference to certain embodiments, those skilled in the art will readily appreciate that changes and/or modifications may be made thereto without departing from the scope of the appended claims.

## Claims

1. An aircraft component (100), comprising:
an aircraft component body (101); and
a plasma heater (103) disposed at least partially on or at least partially within the component (100) and configured to selectively heat the component (100), wherein
the plasma heater (103) includes a vacuum tube (105) having a first end and a second end and configured to retain an inert gas (107), **characterised in that**
the vacuum tube (105) includes a first end electrode (113a) and a second end electrode (113b) configured to be connected to an electrical source (115) to provide an electrical potential to the inert gas (107) within the vacuum tube (105).

2. The component of claim 1, wherein the component (100) is an air data sensor (100), the body (101) is a sensor body (101), and the plasma heater (103) is disposed at least partially on or at least partially within the sensor body (101) and configured to selectively heat the sensor body (101).

3. The component of claim 1 or 2, wherein the component (100) or sensor body (101) is a pitot tube.

4. The component of any preceding claim, wherein the vacuum tube (105) is metallic.

5. The component of any preceding claim, wherein the vacuum tube (105) is coated with an insulation lining (109) configured to prevent escape of electrical charges in the plasma through the vacuum tube (105).

6. The component of any preceding claim, wherein the vacuum tube (105) is integrally formed by the component (100) or the sensor body (101).

7. The component of any preceding claim, wherein the vacuum tube (105) is a separate piece inserted into the component (100) or the sensor body (101).

8. The component of any preceding claim, wherein the vacuum tube (105) at least partially forms a coil (111) within or embedded around the component (100) or the sensor body (101).

9. The component of any preceding claim, wherein the plasma heater (103) further includes a controller (117) configured to control the electrical source (115) to provide an initial electrical potential from the electrical source (115) between the first end electrode (113a) and second end electrode (113b) to establish a charge flow through the inert gas (107), and wherein the controller (117) is configured to control the electrical source (115) to provide a second electrical potential lower than the first electrical potential after charge flow has been established, wherein the second electrical potential maintains charge flow through the inert gas (107).

10. A method, comprising:
heating an aircraft component (100) with a plasma heater (103) to prevent icing of the aircraft component (100), wherein
the plasma heater (103) includes a vacuum tube (105) which has a first end and a second end and retains an inert gas (107),
**characterised in that** the vacuum tube (105) includes a first end electrode (113a) and a second end electrode (113b) configured to be connected to an electrical source (115) to provide an electrical potential to the inert gas (107) within the vacuum tube (105).

## Patentansprüche

1. Flugzeugkomponente (100), umfassend:
einen Flugzeugkomponentenkörper (101); und
einen Plasmaerhitzer (103), der zumindest teilweise auf oder zumindest teilweise innerhalb der Komponente (100) angeordnet und konfiguriert ist, um die Komponente (100) selektiv zu erhitzen, wobei
der Plasmaerhitzer (103) eine Vakuumröhre (105) mit einem ersten Ende und einem zweiten Ende beinhaltet und so konfiguriert ist, dass er ein Inertgas (107) zurückhält, **dadurch gekennzeichnet, dass**
die Vakuumröhre (105) eine erste Endelektrode (113a) und eine zweite Endelektrode (113b) beinhaltet, die konfiguriert sind, um mit einer elektrischen Quelle (115) verbunden zu werden, um ein elektrisches Potential für das Inertgas (107) innerhalb der Vakuumröhre (105) bereitzustellen.

2. Komponente nach Anspruch 1, wobei die Komponente (100) ein Luftdatensensor (100) ist, der Körper (101) ein Sensorkörper (101) ist und der Plasmaerhitzer (103) zumindest teilweise auf oder zumindest teilweise innerhalb des Sensorkörpers (101) angeordnet ist und so konfiguriert ist, dass er den Sensorkörper (101) selektiv erhitzt.

3. Komponente nach Anspruch 1 oder 2, wobei die Komponente (100) oder der Sensorkörper (101) ein Staurohr ist.

4. Komponente nach einem der vorhergehenden Ansprüche, wobei die Vakuumröhre (105) metallisch ist.

5. Komponente nach einem der vorhergehenden Ansprüche, wobei die Vakuumröhre (105) mit einer Isolationsauskleidung (109) beschichtet ist, die konfiguriert ist, um ein Entweichen elektrischer Ladungen in das Plasma durch die Vakuumröhre (105) zu verhindern.

6. Komponente nach einem der vorhergehenden Ansprüche, wobei die Vakuumröhre (105) vollständig durch die Komponente (100) oder den Sensorkörper (101) gebildet ist.

7. Komponente nach einem der vorhergehenden Ansprüche, wobei die Vakuumröhre (105) ein separates Teil ist, das in die Komponente (100) oder den Sensorkörper (101) eingesetzt ist.

8. Komponente nach einem der vorhergehenden Ansprüche, wobei die Vakuumröhre (105) zumindest teilweise eine Spule (111) innerhalb oder eingebettet um die Komponente (100) oder den Sensorkörper (101) bildet.

9. Komponente nach einem der vorhergehenden Ansprüche, wobei der Plasmaerhitzer (103) ferner eine Steuerung (117) beinhaltet, die so konfiguriert ist, dass sie die elektrische Quelle (115) steuert, um ein anfängliches elektrisches Potential von der elektrischen Quelle (115) zwischen der ersten Endelektrode (113a) und der zweiten Endelektrode (113b) bereitzustellen, um einen Ladungsfluss durch das Inertgas (107) herzustellen, und wobei die Steuerung (117) so konfiguriert ist, dass sie die elektrische Quelle (115) steuert, um ein zweites elektrisches Potential bereitzustellen, das niedriger als das erste elektrische Potential ist, nachdem der Ladungsfluss hergestellt wurde, wobei das zweite elektrische Potential den Ladungsfluss durch das Inertgas (107) aufrechterhält.

10. Verfahren, umfassend:
Erhitzen einer Flugzeugkomponente (100) mit einem Plasmaerhitzer (103), um eine Vereisung der Flugzeugkomponente (100) zu verhindern, wobei
der Plasmaerhitzer (103) eine Vakuumröhre (105) mit einem ersten Ende und einem zweiten Ende beinhaltet und ein Inertgas (107) zurückhält, **dadurch gekennzeichnet, dass**
die Vakuumröhre (105) eine erste Endelektrode (113a) und eine zweite Endelektrode (113b) beinhaltet, die konfiguriert sind, um mit einer elektrischen Quelle (115) verbunden zu werden, um ein elektrisches Potential für das Inertgas (107) innerhalb der Vakuumröhre (105) bereitzustellen.

## Revendications

1. Composant (100) d'aéronef comprenant :
un corps de composant d'aéronef (101) ; et
un élément chauffant à plasma (103) disposé au moins partiellement sur ou au moins partiellement à l'intérieur du composant (100) et configuré pour chauffer sélectivement le composant (100), dans lequel
l'élément chauffant à plasma (103) comporte un tube à vide (105) ayant une première extrémité et une seconde extrémité et configuré pour retenir un gaz inerte (107), **caractérisé en ce que**
le tube à vide (105) comporte une première électrode d'extrémité (113a) et une seconde électrode d'extrémité (113b) configurées pour être connectées à une source électrique (115) pour fournir un potentiel électrique au gaz inerte (107) à l'intérieur du tube à vide (105).

2. Composant selon la revendication 1, dans lequel le composant (100) est un capteur de données d'air (100), le corps (101) est un corps de capteur (101) et l'élément chauffant à plasma (103) est disposé au moins partiellement sur ou au moins partiellement à l'intérieur du corps de capteur (101) et configuré pour chauffer sélectivement le corps de capteur (101).

3. Composant selon la revendication 1 ou 2, dans lequel le composant (100) ou corps de capteur (101) est un tube de Pitot.

4. Composant selon une quelconque revendication précédente, dans lequel le tube à vide (105) est métallique.

5. Composant selon une quelconque revendication précédente, dans lequel le tube à vide (105) est revêtu d'un revêtement isolant (109) configuré pour empêcher la fuite de charges électriques dans le plasma à travers le tube à vide (105).

6. Composant selon une quelconque revendication précédente, dans lequel le tube à vide (105) est formé intégralement par le composant (100) ou le corps de capteur (101).

7. Composant selon une quelconque revendication précédente, dans lequel le tube à vide (105) est une pièce séparée insérée dans le composant (100) ou le corps de capteur (101).

8. Composant selon une quelconque revendication précédente, dans lequel le tube à vide (105) forme au moins partiellement une bobine (111) à l'intérieur ou intégrée autour du composant (100) ou du corps de capteur (101).

9. Composant selon une quelconque revendication précédente, dans lequel l'élément chauffant à plasma (103) comprend en outre un dispositif de commande (117) configuré pour réguler la source électrique (115) afin de fournir un potentiel électrique initial à partir de la source électrique (115) entre la première électrode d'extrémité (113a) et une seconde électrode d'extrémité (113b) pour établir un flux de charge à travers le gaz inerte (107), et dans lequel le dispositif de commande (117) est configuré pour réguler la source électrique (115) afin de fournir un second potentiel électrique inférieur au premier potentiel électrique après que le flux de charge a été établi, dans lequel le second potentiel électrique maintient le flux de charge à travers le gaz inerte (107).

10. Procédé, comprenant :
le chauffage d'un composant d'aéronef (100) avec un élément chauffant à plasma (103) pour empêcher le givrage du composant d'aéronef (100), dans lequel
l'élément chauffant à plasma (103) comporte un tube à vide (105) ayant une première extrémité et une seconde extrémité et retient un gaz inerte (107), **caractérisé en ce que**
le tube à vide (105) comporte une première électrode d'extrémité (113a) et une seconde électrode d'extrémité (113b) configurées pour être connectées à une source électrique (115) pour fournir un potentiel électrique au gaz inerte (107) à l'intérieur du tube à vide (105).
